# DEMANDE DE BREVET EUROPEEN

(11) **EP 4 679 996 A1**
(43) Date de publication de la demande: **14.01.2026**
(21) Numéro de dépôt: 25188236.1
(22) Date de dépôt: 08.07.2025
(51) Int. Cl.: H10K 71/15, H10K 71/40, H10K 85/50, H10K 102/00

(54) **PROCEDE DE REALISATION D'UNE COUCHE ACTIVE PEROVSKITE D'HALOGENURE METALLIQUE**

(30) Priorité: 12.07.2024 FR 2407633
(71) Demandeur: Commissariat à l'Energie Atomique et aux Energies Alternatives, 75015 Paris (FR); 3SUN S.r.l., 95121 Catania (CT) (IT)
(72) Inventeur: MANCEAU, Matthieu, 38054 GRENOBLE Cedex 09 (FR); BENGASI, Guiseppe, 95126 CATANIA (IT)
(74) Mandataire: Santarelli

(57) **Abrégé**

L'invention porte sur un procédé de réalisation d'une couche active pérovskite d'halogénure métallique, comportant une première phase de réalisation, pour obtenir une première couche pérovskite, dans laquelle on dépose d'un premier film humide comportant des précurseurs du matériau pérovskite dans un milieu solvant ; puis on soumet le premier film humide à une trempe au gaz, obtenant ainsi la première couche pérovskite, le milieu solvant ayant été éliminé et le matériau pérovskite ayant cristallisé. Le procédé comporte au moins une deuxième phase de réalisation, au cours de laquelle les étapes de la première phase sont réitérées, pour obtenir la couche active pérovskite.

## Description

### DOMAINE TECHNIQUE

Le domaine de l'invention est celui des procédés de réalisation d'une couche active pérovskite d'halogénure métallique, pour des applications dans les domaines, entre autres, des dispositifs photovoltaïques, des diodes électroluminescentes, et des photodétecteurs.

### ÉTAT DE LA TECHNIQUE ANTÉRIEURE

Les pérovskites d'halogénure métallique font partie des matériaux semiconducteurs prometteurs pour le développement des dispositifs optoélectroniques tels que les cellules photovoltaïques, les diodes électroluminescentes, les photodétecteurs, les lasers, etc..., du fait de leurs bonnes propriétés optoélectroniques.

Plusieurs procédés de réalisation d'une telle couche pérovskite existent, comme par exemple le dépôt à la tournette (*spin coating,* en anglais) d'un film humide comportant des précurseurs du matériau pérovskite dilués dans un milieu solvant, suivi d'une trempe à l'anti-solvant (*antisolvent quenching,* en anglais) du film humide.

Par ailleurs, le document EP4265826A1 décrit un autre procédé de réalisation, qui comporte une étape de dépôt d'un film humide par enduction par couchage à lame (*blade coating,* en anglais) suivi d'une étape de trempe au gaz (*gas quenching,* en anglais).

Cependant, il existe un besoin d'être en mesure de réaliser une couche pérovskite épaisse, par exemple dont l'épaisseur est au moins égale à 0.8 µm, voire à 1 µm ou à 1.2 µm. C'est le cas notamment lorsqu'on souhaite que la couche pérovskite recouvre entièrement des pyramides de la face de dépôt d'un substrat sous-jacent texturé. C'est le cas également lorsqu'on souhaite réaliser un dispositif photovoltaïque de type tandem.

Il est alors possible d'augmenter l'épaisseur du film humide, voire d'augmenter la concentration molaire des précurseurs du matériau pérovskite dans ce film humide. Cependant, déposer un film humide plus épais peut conduire à obtenir une couche pérovskite non homogène et dont la qualité cristalline du matériau est insuffisante. Par ailleurs, il peut être difficile d'augmenter davantage la concentration molaire des précurseurs dans le film humide sans atteindre rapidement par la limite de solubilité.

### EXPOSÉ DE L'INVENTION

L'invention a pour objectif de remédier au moins en partie aux inconvénients de l'art antérieur, et plus particulièrement de proposer un procédé de réalisation d'une couche active pérovskite d'halogénure métallique, dont l'épaisseur peut être au moins égale à 0.8 µm, voire à 1 µm ou même à 1.2 µm, et dont le matériau pérovskite présente une bonne qualité cristalline. Un autre objectif est d'obtenir une telle couche active pérovskite sans avoir à déposer un film humide plus épais ni à augmenter la concentration molaire des précurseurs dans le film humide.

Pour cela, l'objet de l'invention est un procédé de réalisation d'une couche active pérovskite d'halogénure métallique, comportant les étapes suivantes :
o fournir un substrat présentant une face de dépôt ;
o une première phase de réalisation, pour obtenir une première couche pérovskite, comportant les étapes suivantes :
   - déposer, sur la face de dépôt, un premier film humide comportant des précurseurs du matériau pérovskite dans un milieu solvant ;
   - soumettre le premier film humide à une trempe au gaz, obtenant ainsi la première couche pérovskite, le milieu solvant ayant été éliminé et le matériau pérovskite ayant cristallisé.

La trempe au gaz (en anglais « gas quenching ») est un procédé où le substrat, qui peut être chauffé, est refroidi de manière contrôlée à l'aide d'un gaz qui peut être quant à lui non-chauffé et projeté à une température inférieure à celle du substrat.

Selon l'invention, le procédé comporte au moins une deuxième phase de réalisation, au cours de laquelle les étapes de la première phase sont réitérées, pour obtenir la couche active pérovskite :
- déposer, sur la première couche pérovskite, un deuxième film humide comportant des précurseurs du matériau pérovskite dans un milieu solvant, conduisant à une dissolution de la première couche pérovskite sous-jacente et donc à l'obtention d'un nouveau film humide ;
- soumettre le nouveau film humide à une trempe au gaz, obtenant ainsi la couche active pérovskite, le milieu solvant ayant été éliminé et le matériau pérovskite ayant cristallisé.

Certains aspects préférés mais non limitatifs de ce procédé de réalisation sont les suivants.

La couche active pérovskite peut présenter une épaisseur au moins égale à 0.8 µm.

La première phase de réalisation peut comporter une étape de traitement thermique effectué à la suite de la trempe au gaz, contribuant à éliminer le milieu solvant du premier film humide. Par ailleurs, au moins la deuxième phase de réalisation peut également comporter une étape de traitement thermique effectué à la suite de la trempe au gaz, contribuant à éliminer le milieu solvant du nouveau film humide.

Les étapes de dépôt peuvent être effectuées par enduction, par couchage par lame ou par enduction par filière à fente.

Le premier film humide et le deuxième film humide peuvent présenter des épaisseurs identiques. Les premier et deuxième films humides peuvent comporter les mêmes précurseurs du matériau pérovskite.

Le premier film humide et le deuxième film humide peuvent présenter des concentrations molaires identiques en précurseurs du matériau pérovskite.

Le premier film humide et le deuxième film humide peuvent présenter des concentrations molaires différentes en précurseurs du matériau pérovskite.

Les étapes de trempe au gaz peuvent avoir les mêmes conditions opératoires, par exemple en termes de température du substrat, de position et d'orientation d'une buse de projection et de vitesse d'un flux gazeux projeté sur le film humide.

Une étape de traitement thermique peut être effectuée à la suite de chaque étape de trempe au gaz, de manière à éliminer un milieu solvant résiduel. Les conditions peuvent être identiques lors des étapes de traitement thermique en termes de température et de durée.

Le matériau pérovskite peut présenter une formule brute ABX₃, où A correspond à un cation ou une combinaison de cations métalliques ou organiques, B correspond à un ou plusieurs éléments métalliques, tels que le plomb Pb, l'étain Sn, le bismuth Bi, l'antimoine Sb, et où X correspond à un ou plusieurs anions, en particulier des halogénures, choisis parmi le chlorure, le bromure, l'iodure et leurs mélanges.

L'élément chimique B peut être du plomb en sur-stœchiométrie.

Le matériau pérovskite peut présenter une formule brute CsₓFA₍₁₋ₓ₎Pb(I_{y}Br_{(1-y)})₃, où FA est le formamidinium.

L'invention porte également sur un procédé de fabrication d'un dispositif photovoltaïque comportant la réalisation d'une couche de type n, d'une couche active pérovskite réalisée par le procédé selon l'une quelconque des caractéristiques précédentes, et une couche de type p.

L'invention porte également sur un empilement à base de pérovskite obtenu à l'aide d'un procédé tel que défini plus haut.

L'invention porte également sur un empilement à base de pérovskite comportant : un substrat présentant une face de dépôt ; une couche active pérovskite, recouvrant la face de dépôt, formé d'un matériau pérovskite et du PbI₂ cristallin, présentant : une épaisseur au moins égale à 0.8µm, et un ratio A_{PK}/A_{PbI2} au moins égal à 1.5, où A_{PK} est une aire d'un pic associé au matériau pérovskite d'un spectre DRX de la couche active pérovskite, et A_{Pbl2} est une aire d'un pic associé au Pbl₂.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
La figure 1A, la figure 1B, la figure 1C, la figure 1D, la figure 1E et la figure 1F illustrent différentes étapes d'un procédé de réalisation d'une couche active pérovskite selon un mode de réalisation.
La figure 2A illustre des vues en coupe transversale par microscopie électronique à balayage d'une couche de référence obtenue par un procédé selon un exemple de l'art antérieur (cf. fig.2A gauche), et d'une couche active pérovskite obtenue par un procédé selon un premier mode de réalisation (cf. fig.2A droite).
La figure 2B illustre des vues de dessus par microscopie électronique à balayage de la même couche de référence (cf. fig.2B gauche), et de la même couche active pérovskite (cf. fig.2B droite) ;
La figure 2C illustre des spectres DRX de la même couche de référence et de la même couche active pérovskite.
La figure 3A est une vue en coupe transversale d'une couche active pérovskite obtenue par un procédé selon un deuxième mode de réalisation.
La figure 3B est une vue de dessus de la même couche active pérovskite.
La figure 3C illustre les spectres DRX de la fig.2C du premier mode de réalisation, ainsi que le spectre DRX de la couche active pérovskite du deuxième mode de réalisation.
La figure 4A illustre des vues de dessus par microscopie électronique à balayage d'une même couche de référence (cf. fig.4A gauche), et d'une couche active pérovskite (cf. fig.4A droite) déposées sur un substrat texturé ;.
La figure 4B est un spectre DRX de la couche active pérovskite de la fig.4A.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de réalisation d'une couche active pérovskite d'halogénure métallique, dont l'épaisseur peut être au moins égale à 0.8 µm, voire à 1 µm ou à 1.2 µm, et dont le matériau pérovskite présente une qualité cristalline élevée.

Pour cela, le procédé de réalisation de la couche active pérovskite repose sur une approche dite « multi-dépôts », c'est-à-dire de plusieurs dépôts successifs d'un film humide, où chaque étape de dépôt est suivie d'une étape de trempe au gaz du film humide déposé.

Ainsi, le procédé de réalisation comporte donc une première phase permettant de réaliser une première couche pérovskite. Cette première phase comporte *a minima* une étape de dépôt d'un premier film humide, suivi d'une trempe au gaz de ce premier film humide. Un traitement thermique peut également être réalisé. On obtient ainsi une première couche pérovskite.

Puis, selon l'invention, le procédé de réalisation comporte au moins une deuxième phase (ou phase supplémentaire) au cours de laquelle on réitère les étapes de la première phase, où le deuxième film humide est déposé sur la première couche pérovskite qui a été obtenue précédemment, ce qui provoque sa dissolution. Comme détaillé par la suite, la couche active pérovskite peut présenter une épaisseur au moins égale à 0.8µm avec une qualité cristalline homogène et élevée.

D'une manière générale, le procédé de réalisation de la couche active pérovskite comporte *a minima* les étapes suivantes :
∘ fournir un substrat présentant une face de dépôt ;
∘ une première phase de réalisation, pour obtenir une première couche pérovskite, comportant les étapes suivantes :
   - déposer, sur la face de dépôt, un premier film humide comportant des précurseurs du matériau pérovskite dans un milieu solvant ;
   - soumettre le premier film humide à une trempe au gaz, de préférence suivi par un traitement thermique, obtenant ainsi la première couche pérovskite, le milieu solvant ayant été éliminé et le matériau pérovskite ayant cristallisé ;
o au moins une deuxième phase de réalisation, effectuée à la suite de la première phase et au cours de laquelle les étapes de la première phase sont réitérées, pour obtenir la couche active pérovskite :
   - déposer, sur la première couche pérovskite, un deuxième film humide comportant des précurseurs du matériau pérovskite dans un milieu solvant, conduisant à une dissolution de la première couche pérovskite sous-jacente et donc à l'obtention d'un nouveau film humide ;
   - soumettre le nouveau film humide à une trempe au gaz, suivi le cas échéant par un traitement thermique, obtenant ainsi la couche active pérovskite, le milieu solvant du nouveau film humide ayant été éliminé et le matériau pérovskite ayant cristallisé ;

Par couche active pérovskite, on entend une couche active, c'est-à-dire absorbante dans la bande spectrale souhaitée, réalisée en un matériau cristallin pérovskite en phase α (également appelée phase noire). Il ne s'agit donc pas d'une couche amorphe ou d'une couche photo-inactive où le matériau est en phase δ (également appelée phase jaune). Certains matériaux pérovskites sont connus sous un acronyme, comme le « MAPI » pour CH₃NH₃PbI₃, et le « FAPI » pour le FAPbI₃ où FA correspond au formamidinium HC(NH₂)₂⁺.

Le matériau pérovskite de la couche active est un matériau de formule brute ABX₃, où :
∘ A correspond à un cation ou une combinaison de cations métalliques ou organiques ;
∘ B correspond à un ou plusieurs éléments métalliques, tels que le plomb Pb, l'étain Sn, le bismuth Bi, l'antimoine Sb ;
∘ X correspond à un ou plusieurs anions, en particulier des halogénures, choisis parmi le chlorure, le bromure, l'iodure et leurs mélanges.

Par ailleurs, le matériau de la couche pérovskite déposée peut ne pas être parfaitement stœchiométrique, mais peut présenter une légère sur-stœchiométrie en l'élément B, par exemple en plomb. Ainsi, dans la formule générale ABX₃, la quantité d'atomes B n'est pas exactement égale à 1, mais pourra être légèrement supérieure à 1, par exemple comprise entre 1.01 et 1.10, par exemple égale à 1.05 environ. Par ailleurs, la couche active pérovskite pourra comporter également des cristaux de BX₂, par exemple du Pbl₂. Toutefois, le procédé de réalisation selon l'invention permet d'obtenir un matériau pérovskite de bonne qualité cristalline, où la quantité de cristaux BX₂ est réduite.

De préférence, le matériau pérovskite de la couche active est de formule brute CsₓFA₍₁₋ₓ₎Pb(I_{y}Br_{(1-y)})₃, où l'élément A est du CsFA, l'élément B est du plomb, et l'élément X est un halogénure choisi parmi l'iodure, le bromure et le mélange de ces deux éléments.

Le substrat, sur lequel les étapes de dépôt sont effectuées, peut être ou peut comporter une plaque de type *wafer* d'une épaisseur de plusieurs dizaines à plusieurs centaines de microns, en un matériau semiconducteur, en verre, saphir ou autres. Il peut comporter des couches de type n ou p, selon l'application visée. Il repose ici sur un porte-substrat qui peut appliquer une température souhaitée.

La face de dépôt du substrat peut être une face plane, ou peut présenter des structurations telles que des pyramides, par exemple d'une dimension (hauteur et largeur à la base) de l'ordre du micron, par exemple égale à 1 µm environ. Ces pyramides peuvent être notamment situées à la surface de mésas. Le substrat peut également présenter une rugosité et/ou des ondulations sur des échelles de plusieurs dizaines voire centaines de microns.

Dans le procédé de réalisation de la couche active pérovskite, chaque phase de réalisation comporte une étape de dépôt d'un film humide comportant des précurseurs du matériau pérovskite dilués dans un milieu solvant.

Ces étapes de dépôt peuvent être effectuées à échelle industrielle, par exemple sur de grandes surfaces (par exemple 5×5cm² voire 15×15cm²), tout en permettant d'obtenir une couche active pérovskite épaisse (au moins égale à 0.8 µm), homogène, et avec une bonne qualité cristalline.

Elles peuvent être effectuées par enduction par couchage par lame (*blade coating,* en anglais), par enduction par filière à fente (*slot die coating,* en anglais), par dépôt à la tournette (*spin coating* en anglais), entre autres. Elles sont effectuées de préférence par enduction de type *blade coating* ou *slot die coating,* de manière à obtenir un film humide à épaisseur constante et à concentration homogène (par ex. sa concentration molaire).

De préférence, la vitesse relative entre la lame d'étalement (*blade coating*) ou la tête de dépôt (*slot die coating*) d'une part et le film humide d'autre part est comprise entre 1 et 100 mm/s, de préférence entre 15 et 45 mm/s, et de préférence entre 20 et 30 mm/s.

Chaque film humide est formé à partir d'une solution de précurseurs du matériau pérovskite dilués dans un milieu solvant. Le solvant peut être le DMF et/ou le DMSO. Les précurseurs peuvent être choisis notamment parmi CsX, FAY, PbZ₂ et leurs combinaisons, avec X, Y, Z choisi parmi I et Br. L'additif FACl peut être présent dans la solution. De préférence, la solution est dépourvue de tout autre additif ainsi que des cations MA⁺ (méthylammonium) dont la présence peut altérer la stabilité de la couche active pérovskite. De préférence, les précurseurs sont le Pbl₂, le PbBr₂, le FAI et le Csl. De préférence, la solution de précurseurs présente une concentration molaire de plomb comprise entre 0.2 et 1.7M, par exemple entre 0.6 et 1.5M, de préférence entre 1 et 1.3M. Il est également possible d'utiliser des films humides présentant les mêmes composants et éléments chimiques mais en quantités différentes, de sorte que la concentration molaire de l'élément B, par exemple du plomb, est différente d'un film humide à l'autre. Par exemple, on pourra utiliser un premier film humide (lors de la première phase) ayant une concentration molaire de plomb de c_{Pb1}, et d'un deuxième film humide (lors de la deuxième phase) avant une concentration molaire de plomb c_{Pb2} supérieure ou inférieure à c_{Pb1}. Par exemple, on peut avoir c_{Pb1} égale à 0.2M et c_{Pb2} égale 1M (comme décrit plus loin dans le deuxième mode de réalisation).

Le film humide déposé présente de préférence une épaisseur constante, par exemple comprise entre 2 et 16 µm, de préférence comprise entre 2.5 et 8 µm, et de préférence encore comprise entre 3 et 5 µm. Dans cette gamme d'épaisseur, et en fonction de la concentration molaire du premier film humide, il est possible d'obtenir une première couche pérovskite d'épaisseur comprise entre 0.3 et 0.6 µm environ (avec une concentration molaire de plomb comprise entre 0.6 et 1M). Le fait que le procédé de réalisation selon l'invention soit de type « multi-dépôt » permet d'obtenir une couche active pérovskite d'épaisseur plus importante, par exemple au moins égale à 0.8 µm, voire à 1 µm, ou même à 1.2 µm.

Ainsi, les conditions opératoires lors des étapes de dépôt sont notamment la technique utilisée et les conditions associées, ainsi que la température du substrat, entre autres. De préférence, ces conditions opératoires sont identiques lors des différentes étapes de dépôt du procédé de réalisation.

Lors des étapes de trempe au gaz (*gas quenching* en anglais), on balaye la surface du film humide par un flux de gaz, comme de l'air sec, de l'azote ou de l'argon (de préférence un gaz inerte). De préférence, on balaye la totalité de la surface du film humide.

Cette étape peut être effectuée alors que l'étape de dépôt du film humide n'est pas encore terminée, ou après qu'elle le soit. Une buse de projection d'un couteau à gaz (*gas knife,* en anglais) peut être utilisée. Son extrémité est située à une distance verticale vis-à-vis de la face libre du film humide, et elle peut être inclinée d'un angle donné vis-à-vis d'un plan passant par le film humide. Cet angle peut être compris entre 30 et 90°, par exemple égal à 50°. La longueur de la trajectoire du flux gazeux peut être comprise entre 3 et 6 mm, par exemple entre 3 et 4 mm.

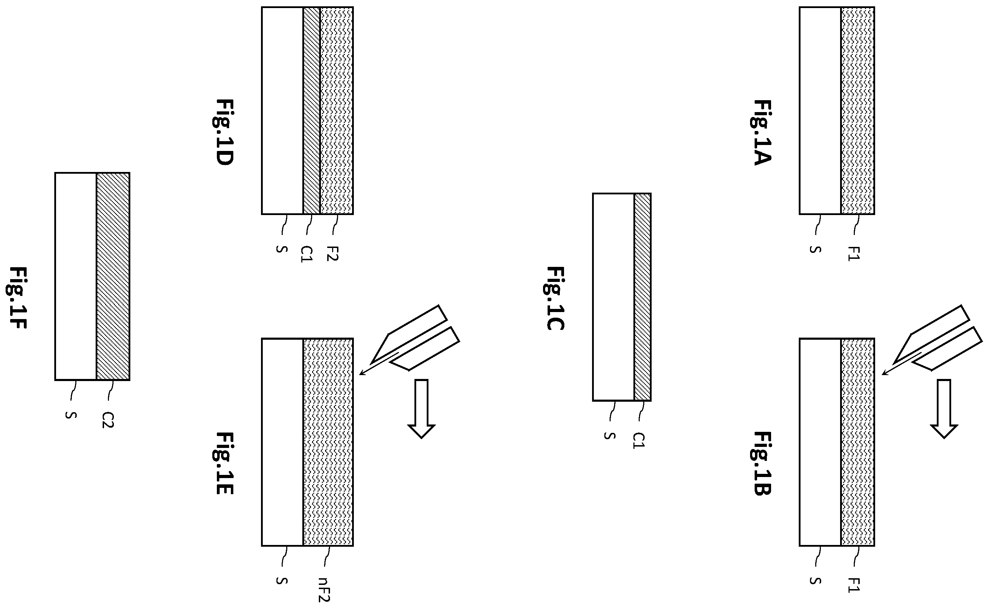

La vitesse du flux gazeux peut être mesurée à la sortie de la buse de projection, i.e. à l'extrémité d'une des lèvres d'extrémité de la buse. Sur les fig.1B et 1E, la lèvre supérieure est plus courte que la lèvre inférieure, mais d'autres configurations sont possibles. La vitesse du flux gazeux peut être comprise entre 120 et 250 m/s. Par ailleurs, la buse de projection présente une vitesse de déplacement vis-à-vis du film humide qui peut être comprise entre 1 et 50 mm/s, par exemple entre 5 et 30 mm/s.

Ainsi, les conditions opératoires lors des étapes de trempe au gaz sont notamment le positionnement et l'orientation de la buse de projection vis-à-vis de la face libre du film humide, la vitesse du flux gazeux et la vitesse de déplacement de la buse, et la température du substrat, entre autres. De préférence, ces conditions opératoires sont identiques lors des différentes étapes de trempe au gaz du procédé de réalisation.

Lors du dépôt, le substrat est maintenu à une de préférence température constante, typiquement comprise entre 30 et 70°C, avantageusement entre 40 et 60°C et par exemple égale à 40°C. Lors de la trempe au gaz, un chauffage du substrat à une température dans une gamme précitée, par exemple à 40°C, peut être mis en œuvre, tandis que le gaz projeté sur la surface exposée du film humide est quant à lui à une température inférieure à celle du substrat et est typiquement non-chauffé. La température du gaz projeté, sans étape de chauffage intermédiaire, est typiquement comprise entre 15°C à 25°C. La trempe au gaz permet de réaliser un refroidissement et participe à une évaporation du ou des solvants et d'initier une recristallisation.

De préférence, à la suite de chaque étape de trempe au gaz, un traitement thermique peut être effectué sous atmosphère inerte. La température du substrat, et de préférence de l'empilement obtenu (substrat et couche pérovskite), est de préférence comprise entre 70°C et 100°C, pendant une durée comprise par exemple entre 5 et 60 min, par exemple entre 5 et 30 min. Cette étape de recuit est avantageuse pour éliminer le solvant résiduel à la suite de l'étape de trempe au gaz.

De préférence, les conditions opératoires, en termes de température, de durée et d'atmosphère, sont identiques lors des différentes étapes de traitement thermique du procédé de réalisation.

Les figures 1A à 1F illustrent des étapes d'un procédé de réalisation d'une couche active pérovskite selon un premier mode de réalisation. Les figures 1A à 1C sont relatives à la première phase, et les figures 1D à 1F sont relatives à la deuxième phase. Le procédé comporte en effet ici deux phases de réalisation successives, où les conditions opératoires sont identiques. La couche active pérovskite est réalisée dans cet exemple pour fabriquer une cellule photovoltaïque tandem Si/PK, comprenant une sous-cellule à hétérojonction silicium en configuration PIN et une sous-cellule à base de pérovskite.

En référence à la fig.1A, on fournit tout d'abord un substrat présentant une face de dépôt. Pour cela, on réalise le dépôt d'une couche fine de passivation en silicium amorphe intrinsèque a-Si:H sur les deux faces opposées d'une plaque (*wafer* en anglais) de silicium cristallin c-Si. Ensuite, on dépose des couches semiconductrices de silicium dopé de type p et dopé de type n respectivement sur les faces arrière et avant de la plaque de silicium cristallin. Pour réaliser le contact électrique avec la cellule photovoltaïque inférieure, un multicouche ITO/Ag est déposé sur la face arrière, et une couche d'ITO par exemple de 12nm d'épaisseur est déposée sur la face avant. La face de dépôt est ici plane. Lors des étapes de dépôt et de trempe au gaz, le substrat est maintenu à une température constante, ici égale à 40°C.

Toujours en référence à la fig.1A, on dépose sur la face de dépôt du substrat S un premier film humide F1 à partir d'une solution de précurseurs du matériau pérovskite dilués dans un milieu solvant. La solution de précurseurs a été préparée à partir du PbI₂ (3.707 g), PbBr₂ (1.453 g), FAI (1.631 g) et Csl (0.468 g), dans un milieu solvant de 12 ml, ici du DMF (10.8 ml) et du DMSO (1.2 ml). La concentration molaire de plomb est 1M, et le rapport molaire Cs/Pb est de 15%. La solution de précurseurs est agitée, par exemple pendant 12h à 40°C.

Le dépôt est réalisé par enduction de type *blade coating.* La distance entre l'extrémité de la lame d'étalement et la face de dépôt est ici de 70 µm. La vitesse relative de déplacement de la lame d'étalement vis-à-vis du substrat S est ici de 20 mm/s, et le volume d'encre utilisé est de 20 µL.

En référence à la fig.1B, on effectue une trempe au gaz du premier film humide F1. Pour cela, un flux gazeux, ici de l'azote, est appliqué sur la surface libre du film humide F1 avec une vitesse de 137 m/s. La buse de projection du flux gazeux est disposée de sorte que la longueur de trajectoire du flux gazeux jusqu'au film humide F1 est de 3.6 mm. De plus, la buse se déplace le long du film humide F1 à une vitesse par exemple de 5 mm/s. Elle est orientée vis-à-vis de la surface libre du film humide F1 de manière à former un angle de 50°. Cette étape provoque une élimination partielle ou totale du milieu solvant, ainsi que la cristallisation du matériau pérovskite.

En référence à la fig.1C, on effectue ensuite un traitement thermique de la couche pérovskite C1 obtenue. Le substrat S est ainsi porté à une température de 100°C pendant 5 min sous atmosphère inerte. Cette étape facultative mais avantageuse permet essentiellement d'éliminer le milieu solvant résiduel. Ainsi, on obtient une première couche pérovskite C1.

On effectue ensuite la deuxième phase de réalisation, pour obtenir la couche active pérovskite C2. Les conditions opératoires des étapes de dépôt, de la trempe au gaz et du traitement thermique sont identiques à celles de la première phase de réalisation.

En référence à la fig.1D, on dépose un deuxième film humide F2 à partir de la même solution de précurseurs. Le deuxième film humide F2 est déposé directement sur la face libre de la première couche pérovskite C1, toujours par enduction de type *blade coating.* Les conditions opératoires (température, vitesse relative, positionnement de la lame d'étalement...) sont identiques à celles de la première étape de dépôt.

Il apparaît que cette étape de dépôt provoque la dissolution totale ou partielle de la première couche pérovskite C1 sous-jacente. On obtient alors un nouveau film humide nF2, dont la quantité du milieu solvant reste évidemment égale à celle du deuxième film humide F2, mais avec une concentration molaire de précurseurs, et notamment une concentration molaire de plomb, supérieure à celle du deuxième film humide F2. L'épaisseur du nouveau film humide nF2 est supérieure à celles des premier et deuxième films humides F1, F2.

En référence à la fig.1E, on effectue une trempe au gaz du nouveau film humide nF2. Les conditions opératoires, en termes de positionnement et d'orientation de la buse de projection, de température et de vitesse de déplacement, restent identiques à celles de la première étape de trempe au gaz. Cette étape provoque une élimination partielle ou totale du milieu solvant, ainsi que la cristallisation du matériau pérovskite.

En référence à la fig.1F, on effectue enfin un traitement thermique de la couche pérovskite obtenue. Le substrat est ainsi porté à une température de 100°C pendant 5 min sous atmosphère inerte.

On obtient ainsi la couche active pérovskite C2, ici d'une épaisseur de 1.2µm environ, après élimination de tout le milieu solvant du nouveau film humide nF2 et cristallisation du matériau pérovskite.

On cherche maintenant à comparer certaines caractéristiques de la couche active pérovskite obtenue C2 selon le premier mode de réalisation avec une couche de référence. La couche de référence est ici identique à la première couche pérovskite C1, c'est-à-dire à la couche obtenue au terme de la première phase de réalisation.

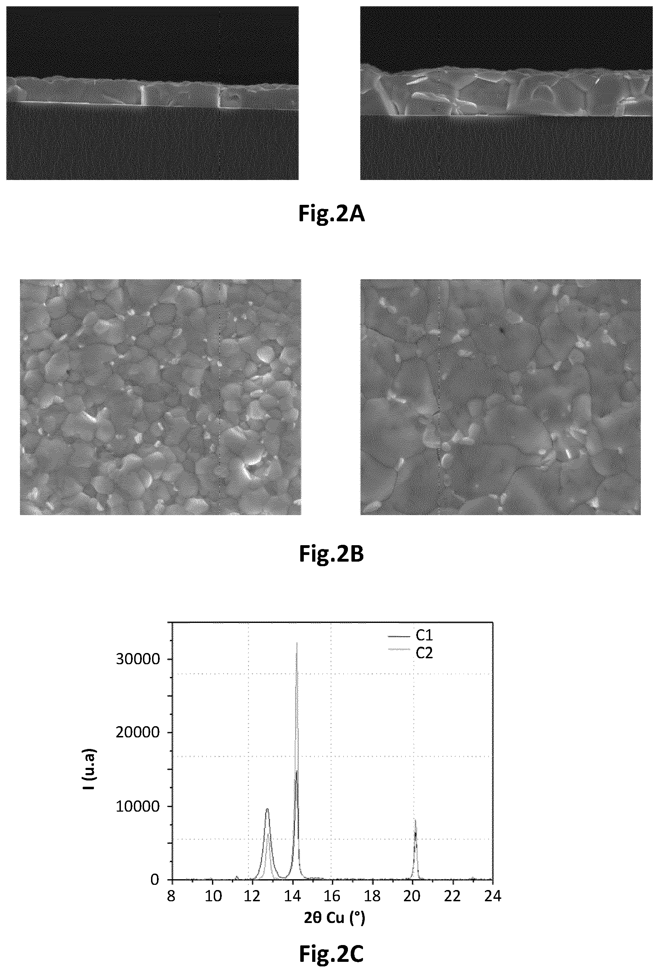

La figure 2A illustre des vues en coupe transversale au microscope électronique à balayage de la couche de référence (fig.2A gauche) et de la couche active pérovskite obtenue par le procédé à double dépôt selon cet exemple de l'invention (fig.2A droite). Il apparaît que la couche active pérovskite présente une épaisseur (ici de 1.2µm) supérieure à celle de la couche de référence (ici de l'ordre de 0.6 à 0.7 µm). On remarque également que la couche active pérovskite ne présente pas de trous dans son épaisseur qui peuvent être observés lorsqu'on cherche à réaliser une trempe à l'anti-solvant d'un film humide d'une grande épaisseur. Enfin, on observe une certaine homogénéité cristalline en épaisseur de la couche active pérovskite. Notons que l'on voit ici des domaines cristallins du matériau pérovskite, formés d'un ou plusieurs grains cristallins.

La figure 2B illustre des vues de dessus, toujours au microscope électronique à balayage, de la couche de référence (fig.2B gauche) et de la couche active pérovskite obtenue par le procédé à double dépôt selon cet exemple de l'invention (fig.2B droite). On remarque que les domaines cristallins de la couche active pérovskite sont de plus grande taille que dans le cas de la couche de référence. Ici également, on remarque une absence de trous, par exemple de type *pinhole,* dans la couche active pérovskite.

La figure 2C illustre des spectres DRX (diffraction aux rayons X) de la couche de référence C1 et de la couche active pérovskite C2. On remarque que le pic à 2θ=14° associé du matériau pérovskite (phase α, et orientation cristallographique (001)) présente une intensité plus grande que celle du pic associé à la couche de référence (2θ=12.5°). De plus, le pic associé au PbI₂ est moins intense et plus étroit.

On peut alors caractériser ces couches pérovskites à partir d'un ratio A_{PK}/A_{PbI2}, où A_{PK} est l'aire du du pic associé au matériau pérovskite PK à 2θ=14°, et A_{PbI2} est l'aire du pic associé au PbI₂ à 2θ=12.5°. Dans le cas de la couche de référence, l'aire A_{PK} est égale à 3499 et l'aire A_{Pbl2} est égale à 4590, conduisant à un ratio A_{PK}/A_{PbI2} égal à 0.76. En revanche, dans le cas de la couche active pérovskite, l'aire A_{PK} est égale à 6063 et l'aire A_{Pbl2} est égale à 1651, conduisant à un ratio A_{PK}/A_{PbI2} égal à 3.67, soit près de 400% supérieur. L'aire est déterminée en calculant l'intégrale sous la courbe considérée au moyen d'un logiciel d'analyse graphique.

La valeur de ce ratio A_{PK/}A_{Pbl2} de la couche active pérovskite est surprenante, dans la mesure où la deuxième phase de réalisation est réalisée dans les mêmes conditions que la première phase de réalisation. Elle traduit une meilleure qualité cristalline de la couche active pérovskite en comparaison à celle de la couche de référence, de sorte qu'elle devrait présenter une meilleure stabilité à long terme de sa structure cristalline et donc de ses propriétés optoélectroniques.

Notons que l'utilisation d'une solution initiale de précurseurs ayant une concentration molaire en plomb de 1.4M peut conduire à former, au terme des deux phases de réalisation, une couche active pérovskite d'une plus grande épaisseur, ici de 1.5µm au lieu de 1.2µm.

Dans un deuxième mode de réalisation, on réalise la couche active pérovskite par un procédé identique à celui du premier mode en termes de conditions opératoires, et qui s'en distingue uniquement par le fait que la concentration molaire de plomb du premier film humide F1 est de 0.2M alors que celle du deuxième film humide F2 reste de 1M.

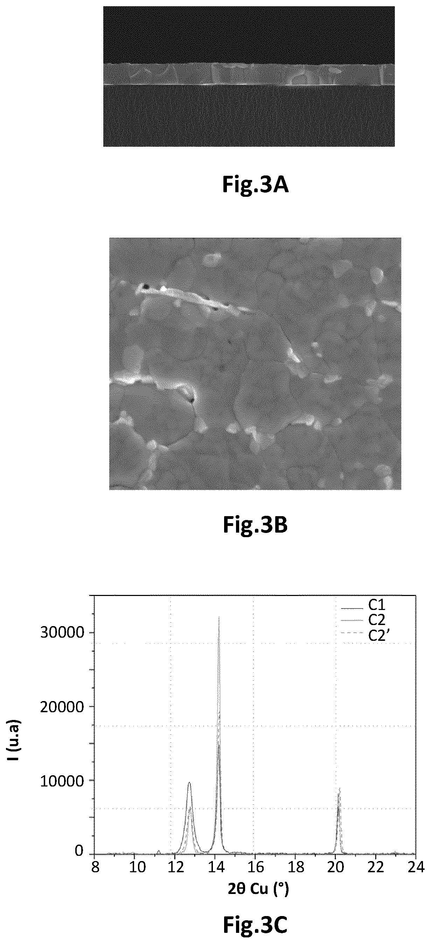

La figure 3A est une vue en coupe transversale au microscope électronique à balayage de la couche active pérovskite obtenue par le procédé à double dépôt selon cet exemple de l'invention. Il apparaît que la couche active pérovskite présente une épaisseur de l'ordre de 0.9 à 1µm, qui reste toujours supérieure à celle de la couche de référence (de l'ordre de 0.6 à 0.7 µm), mais inférieure à l'épaisseur de 1.2µm de la couche active pérovskite du premier mode de réalisation. De plus, la couche active pérovskite présente une certaine homogénéité cristalline en épaisseur : on ne retrouve pas une inhomogénéité en épaisseur qui proviendrait du fait que le premier film humide présente une concentration molaire en plomb inférieure à celle du deuxième film humide.

La figure 3B est une vue de dessus de la couche active pérovskite de la fig.3A. Comme dans le premier mode de réalisation, les domaines cristallins sont plus grands que ceux de la couche de référence. Ici également, on remarque une absence de trous, par exemple de type *pinhole,* dans la couche active pérovskite.

La figure 3C correspond à la fig.2C précédente dans laquelle a été ajouté le spectre DRX de la couche active pérovskite C2' de ce deuxième mode de réalisation. On remarque que le pic du matériau pérovskite PK présente une intensité également plus grande que celui de la couche de référence. De plus, le pic associé au PbI₂ (2θ=12.5°) est similaire à celui de la couche active pérovskite C2 du premier mode.

Par ailleurs, on peut également calculer le ratio A_{PK}/A_{PbI2} pour cette couche active pérovskite C2' à premier film humide dilué : l'aire A_{PK} est égale à 4147 et l'aire A_{Pbl2} est égale à 2257, conduisant à un ratio A_{PK}/A_{PbI2} égal à 1.84, soit une amélioration de 140% comparé à la couche de référence. La couche active pérovskite C2' à premier film humide dilué présente donc également une meilleure qualité cristalline que la couche de référence C1.

Aussi, l'invention porte également sur un empilement à base de pérovskite, comportant un substrat ayant une face de dépôt, laquelle est recouverte par une couche active pérovskite qui est formée d'un matériau pérovskite et de PbI₂ cristallin, la couche active pérovskite présentant une épaisseur au moins égale à 0.8µm et un ratio A_{PK}/A_{PbI2} au moins égal à 1.5, où A_{PK} est une aire d'un pic associé au matériau pérovskite d'un spectre DRX de la couche active pérovskite, et A_{Pbl2} est une aire d'un pic associé au Pbl₂.

Dans un troisième mode de réalisation, la couche active pérovskite n'est pas réalisée sur un substrat dont la face de dépôt est plane, mais sur un substrat texturé (i.e. structuré) où la face de dépôt présente des pyramides d'une taille caractéristique (base et hauteur) de l'ordre de 1µm. Cette configuration se rencontre notamment lors de la fabrication de dispositifs photovoltaïques tandem, par exemple Si/PK ou PK/PK. L'objectif ici est de réaliser une couche active pérovskite qui recouvre continûment les pyramides.

Ici, le premier et le deuxième films humides sont réalisés à partir d'une solution de précurseurs dont la concentration molaire en plomb est de 1.4M. Elle a été préparée en mélangeant 4.324g de PbI₂, 1.696g de PbBr₂, 1.902g de FAI, et 0.546g de Csl dans 10ml d'un milieu solvant formé de 9ml de DMF et 1ml de DMSO.

Les étapes de dépôt, de trempe et de traitement thermique sont identiques à celles décrites dans le premier mode de réalisation, sauf en ce qui concerne la distance entre l'extrémité de la lame d'étalement et la face de dépôt qui est de 90µm.

La couche de référence est obtenue à l'issue de la première phase de réalisation. En revanche, la couche active pérovskite est obtenue à l'issue des deux phases de réalisation.

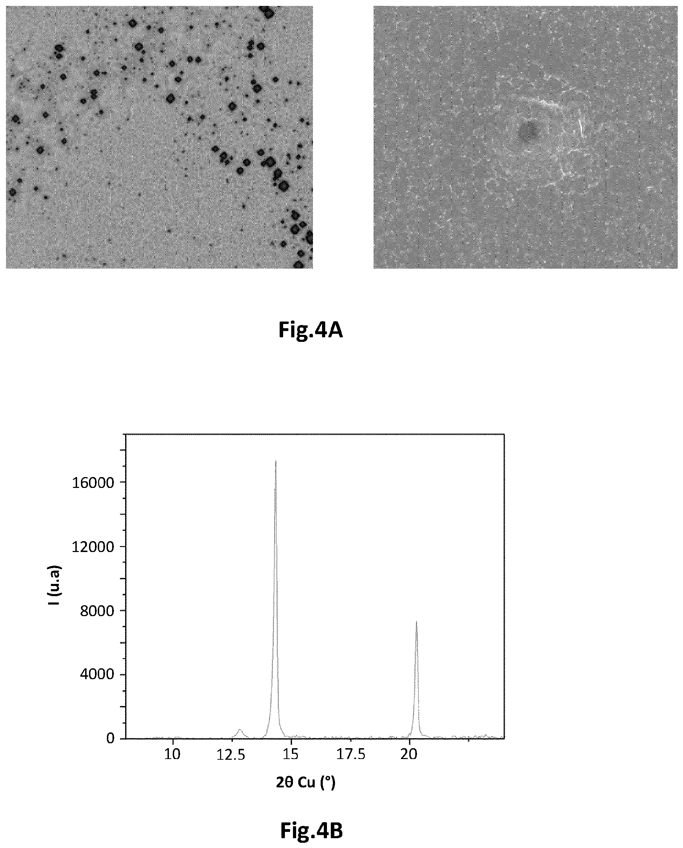

La figure 4A illustre des vues de dessus, au microscope électronique à balayage, de la couche de référence (fig.4A gauche) et de la couche active pérovskite obtenue par le procédé à double dépôt selon cet exemple de l'invention (fig.4B droite). On remarque que, dans le cas de la couche de référence, les sommets de certaines pyramides sont visibles (zones noires), ce qui montre que la couche de référence ne recouvre pas continûment les pyramides. En revanche, dans le cas de la couche active pérovskite, les pyramides sont entièrement recouvertes (pas de zones noires). De plus, la couche active pérovskite ne présente pas de trous, comme ça pourrait être le cas si l'on avait réalisé une couche pérovskite avec un procédé « simple dépôt » de l'art antérieur.

La figure 4B est un spectre DRX de la couche active pérovskite obtenue. On remarque que le pic de la phase α du matériau pérovskite PK (2θ=14°) présente une intensité toujours très grande, alors que le pic associé au PbI₂ (2θ=12.5°) est très faible et étroit. Le ratio A_{PK/}A_{PbI2} est donc particulièrement élevé. La couche active pérovskite présente donc également une très bonne qualité cristalline.

Des modes de réalisation particuliers viennent d'être décrits. Différentes variantes et modifications apparaîtront à l'homme du métier.

## Revendications

1. Procédé de réalisation d'une couche active pérovskite d'halogénure métallique, comportant les étapes suivantes :
o fournir un substrat présentant une face de dépôt ;
o une première phase de réalisation, pour obtenir une première couche pérovskite, comportant les étapes suivantes :
• déposer, sur la face de dépôt, un premier film humide comportant des précurseurs du matériau pérovskite dans un milieu solvant puis ;
• soumettre le premier film humide à une trempe au gaz, obtenant ainsi la première couche pérovskite, le milieu solvant ayant été éliminé et le matériau pérovskite ayant cristallisé ;
o **caractérisé en ce qu'**il comporte au moins une deuxième phase de réalisation, au cours de laquelle les étapes de la première phase sont réitérées, pour obtenir la couche active pérovskite :
• déposer, sur la première couche pérovskite, un deuxième film humide comportant des précurseurs du matériau pérovskite dans un milieu solvant, conduisant à une dissolution de la première couche pérovskite sous-jacente et donc à l'obtention d'un nouveau film humide puis ;
• soumettre le nouveau film humide à une trempe au gaz, obtenant ainsi la couche active pérovskite, le milieu solvant ayant été éliminé et le matériau pérovskite ayant cristallisé.

2. Procédé de réalisation selon la revendication 1, dans lequel la couche active pérovskite présente une épaisseur au moins égale à 0.8 µm.

3. Procédé de réalisation selon la revendication 1 ou 2, dans lequel la première phase de réalisation comporte une étape de traitement thermique effectué à la suite de la trempe au gaz, contribuant à éliminer le milieu solvant du premier film humide, et au moins la deuxième phase de réalisation comporte également une étape de traitement thermique effectué à la suite de la trempe au gaz, contribuant à éliminer le milieu solvant du nouveau film humide.

4. Procédé de réalisation selon l'une quelconque des revendications 1 à 3, dans lequel les étapes de dépôt sont effectuées par enduction, par couchage par lame ou par enduction par filière à fente.

5. Procédé de réalisation selon l'une quelconque des revendications 1 à 4, dans lequel le premier film humide et le deuxième film humide présentent des épaisseurs identiques.

6. Procédé de réalisation selon l'une quelconque des revendications 1 à 5, dans lequel les premier et deuxième films humides comportent les mêmes précurseurs du matériau pérovskite.

7. Procédé de réalisation selon l'une quelconque des revendications 1 à 6, dans lequel le premier film humide et le deuxième film humide présentent des concentrations molaires identiques en précurseurs du matériau pérovskite.

8. Procédé de réalisation selon l'une quelconque des revendications 1 à 6, dans lequel le premier film humide et le deuxième film humide présentent des concentrations molaires différentes en précurseurs du matériau pérovskite.

9. Procédé de réalisation selon l'une quelconque des revendications 1 à 8, dans lequel les étapes de trempe au gaz ont les mêmes conditions opératoires.

10. Procédé de réalisation selon l'une quelconque des revendications 1 à 9, dans lequel une étape de traitement thermique est effectuée à la suite de chaque étape de trempe au gaz, de manière à éliminer un milieu solvant résiduel.

11. Procédé de réalisation selon l'une quelconque des revendications 1 à 10, dans lequel le matériau pérovskite présente une formule brute ABX₃, où A correspond à un cation ou une combinaison de cations métalliques ou organiques, B correspond à un ou plusieurs éléments métalliques, tels que le plomb Pb, l'étain Sn, le bismuth Bi, l'antimoine Sb, et où X correspond à un ou plusieurs anions, en particulier des halogénures, choisis parmi le chlorure, le bromure, l'iodure et leurs mélanges.

12. Procédé de réalisation selon l'une quelconque des revendications 1 à 11, dans lequel l'élément chimique B est du plomb en sur-stœchiométrie.

13. Procédé de réalisation selon l'une quelconque des revendications 1 à 12, dans lequel le matériau pérovskite présente une formule brute CsₓFA₍₁₋ₓ₎Pb(I_{y}Br_{(1-y)})₃, où FA est le formamidinium.

14. Procédé de fabrication d'un dispositif photovoltaïque comportant la réalisation d'une couche de type n, d'une couche active pérovskite réalisée par le procédé selon l'une quelconque des revendications précédentes, et une couche de type p.

15. Empilement à base de pérovskite obtenu à l'aide d'un procédé selon l'une des revendications 1 à 13 comportant :
∘ un substrat présentant une face de dépôt ;
∘ une couche active pérovskite, recouvrant la face de dépôt, formé d'un matériau pérovskite et du PbI₂ cristallin, présentant :
• une épaisseur au moins égale à 0.8µm, et
• un ratio A_{PK}/A_{PbI2} au moins égal à 1.5, où A_{PK} est une aire d'un pic associé au matériau pérovskite d'un spectre DRX de la couche active pérovskite, et A_{Pbl2} est une aire d'un pic associé au Pbl₂.
